# FASCICULE DE BREVET EUROPEEN

(11) **EP 4 716 451 B1**
(45) Date de publication et mention de la délivrance du brevet: **09.12.2026**
(21) Numéro de dépôt: 25201475.8
(22) Date de dépôt: 10.09.2025
(51) Int. Cl.: H10W 72/20, H10W 72/00, H10W 90/00

(54) **BOÎTIER DE CIRCUIT INTÉGRÉ ET PROCÉDÉ DE FABRICATION**
GEHÄUSE FÜR INTEGRIERTE SCHALTUNG UND HERSTELLUNGSVERFAHREN
INTEGRATED CIRCUIT PACKAGE AND METHOD OF MANUFACTURE

(30) Priorité: 19.09.2024 FR 2409984
(43) Date de publication de la demande: 25.03.2026
(73) Titulaire: STMicroelectronics International N.V., 1228 Plan-les-Ouates, Geneva (CH)
(72) Inventeur: BOUTALEB, Younes, 38000 Grenoble (FR)
(74) Mandataire: Casalonga

(56) Documents cités:
- US-A1- 2021 082 856

## Description

Des modes de réalisation et de mise en œuvre concernent le domaine du conditionnement (« packaging » en anglais) de circuits intégrés, et plus particulièrement la structure et la fabrication de boîtiers de circuits intégrés, par exemple mais non exclusivement des boîtiers optiques.

Les boîtiers comprennent classiquement un substrat support sur lequel est montée au moins une puce électronique.

Cette puce comporte typiquement sur sa face avant des plages de contact (« pad » en anglais) qui sont connectées électriquement à des zones de soudure (« connus par l'homme du métier sous la dénomination anglosaxonne « bond fingers ») disposées sur la face avant du substrat support par des fils de liaison électriquement conducteurs (« cette opération est connue par l'homme du métier sous la dénomination anglosaxonne « wire bonding »).

Cependant lors de l'opération de montage de la puce sur le substrat support, celle-ci est collée par l'intermédiaire d'une couche de colle.

Le document US 2021/082856 A1 décrit un boîtier de circuits intégrés de l'art antérieur, comprenant une pluralité de piliers de colle photosensible entre une puce flip-chip et un substrat.

Or lorsqu'on presse la puce sur la couche de colle, cette dernière peut dans certains cas déborder sur une partie de certaines au moins des zones de soudure du substrat porteur et/ou remonter le long des parois latérales de la puce pour venir recouvrir au moins partiellement au moins certaines plages de contact de la puce.

Il en résulte alors une contamination de ces parties recouvertes par la colle ce qui conduit à un défaut de soudure des fils de liaison et donc à un défaut de fonctionnement du circuit intégré.

Il existe donc un besoin de remédier à cet inconvénient.

Selon un mode de réalisation il est proposé de contenir la colle entre la face arrière de la puce et la face avant du substrat porteur lors du placement et de la fixation de la puce sur le substrat porteur.

Selon un aspect, il est proposé un boîtier comprenant une puce électronique comportant une face avant possédant des plages de contact (« pads ») et une face arrière possédant plusieurs premiers orifices borgnes répartis sur sa périphérie et débouchant sur la face arrière.

Bien que cela ne soit pas indispensable, il est recommandé de prévoir au moins quatre premiers orifices borgnes.

Une puce est généralement rectangulaire (éventuellement avec des côtés égaux formant alors un carré).

Dans ce cas les quatre premiers orifices borgnes sont de préférence disposés au voisinage des quatre coins de la face arrière de la puce électronique.

Le boîtier comporte également un substrat porteur possédant une face avant (ou face de montage) en vis-à-vis et à distance de la face arrière de la puce électronique.

La face avant du substrat porteur possèdent des zones de soudure (« bond fingers ») et plusieurs deuxièmes orifices borgnes débouchant sur la face avant respectivement en vis-à-vis des premiers orifices borgnes de la puce.

Lorsque la face arrière de la puce électronique possède au moins quatre premiers orifices borgnes, la face avant du substrat porteur possède au moins quatre deuxièmes orifices borgnes.

La face arrière de la puce peut comporter quatre autres premiers orifices borgnes respectivement disposés entre les quatre premiers orifices borgnes et dans ce cas, la face avant du substrat porteur comporte quatre autres deuxièmes orifices borgnes respectivement situés en vis-à-vis des quatre autres premiers orifices borgnes.

Chaque paire d'un premier orifice borgne et d'un deuxième orifice borgne mutuellement en vis-à-vis définit un logement.

Le boîtier comporte alors dans chaque logement, un pilier d'un premier matériau adhésif, par exemple un pilier de colle solidifiée.

Le boîtier comporte également des fils de liaison électriquement conducteurs entre les plages de contact de la puce et les zones de soudure du substrat.

Le boîtier comporte encore un matériau d'enrobage, par exemple une résine de moulage, enrobant les fils de liaison et au moins partiellement la puce électronique.

Une partie de ce matériau d'enrobage est situé dans l'espace entre la face arrière de la puce et la face avant du substrat porteur.

Ainsi selon cet aspect, la puce électronique est fixée sur le substrat par l'intermédiaire des piliers de matériau adhésif.

Et ce matériau adhésif est contenu dans chaque logement formé par une paire d'un premier orifice borgne et d'un deuxième orifice borgne.

Il n'y a donc aucune contamination des plages de contact et des zones de soudure ce qui permet d'obtenir une soudure correcte des fils de liaison d'une part sur ces plages de contact et d'autre part sur les zones de soudure.

Dans le cas de certains boîtiers, le matériau d'enrobage enrobe totalement la puce électronique.

Par contre ce n'est pas le cas pour un boîtier optique, c'est-à-dire un boîtier destiné à contenir une puce équipée d'un dispositif optique émetteur et/ou récepteur de signaux optiques.

En effet pour un tel boîtier le matériau d'enrobage enrobe seulement partiellement la puce électronique.

Plus précisément et selon un mode de réalisation, le boîtier optique comporte un élément optiquement transparent, par exemple une glace, situé en face et à distance de la face avant de la puce et fixé sur cette face avant par un cordon d'un deuxième matériau adhésif, par exemple un cordon de colle.

Ce deuxième matériau adhésif peut être identique ou différent du premier matériau adhésif.

Ce cordon du deuxième matériau adhésif définit avec la puce et l'élément optiquement transparent une cavité qui n'est pas remplie par le matériau d'enrobage.

D'une façon générale l'homme du métier saura définir les caractéristiques géométriques des premiers trous borgnes et des deuxièmes trous borgnes ainsi que la quantité de premier matériau adhésif de façon à obtenir des piliers adhésifs remplissant ces orifices borgnes tout en ménageant un espace entre la face arrière de la puce et la face avant du substrat porteur.

Cela étant les deuxièmes orifices borgnes peuvent avoir une profondeur de 25 micromètres à 10% près.

En pratique le substrat porteur peut être du type multicouches (connu par l'homme du métier sous l'expression anglosaxonne « laminate substrate »).

Un tel substrat porteur comporte une alternance de couches métalliques et de couches électriquement isolantes.

Des pistes métalliques formées dans les couches métalliques ainsi que des vias entre ces pistes permettent de réaliser un réseau d'interconnexion être les zones de soudure de la face avant (face supérieure) du substrat porteur et des billes de soudure disposées sur la face arrière (face inférieure) du substrat porteur et destinées à être soudées sur une carte de circuit imprimé.

La face supérieure de la couche électriquement isolante supérieure du substrat porteur formant la face avant de ce substrat porteur et les deuxièmes orifices borgnes peuvent être ménagés dans la couche électriquement isolante supérieure et avoir une profondeur correspondant à l'épaisseur de cette couche isolante supérieure.

Les deuxièmes orifices borgnes peuvent avoir à titre d'exemple, une ouverture de 200 micromètres à 10% près.

Les premiers orifices borgnes (ménagés sur la face arrière de la puce) peuvent avoir une profondeur inférieure à celle des deuxièmes orifices borgnes, par exemple une profondeur de 10 micromètres à 10% près.

Selon un mode de réalisation, chaque pilier du premier matériau adhésif déborde de 20 micromètres à 10% près, au-dessus de la face avant du substrat porteur.

L'espace entre la face arrière de la puce électronique et la face avant du substrat a alors cette valeur de 20 micromètres à 10% près.

Selon un autre aspect, il est proposé un procédé de fabrication d'un boîtier.

Ce procédé comprend une fourniture d'une puce électronique comportant une face avant possédant des plages de contact et une face arrière.

une formation sur ladite face arrière de plusieurs premiers orifices borgnes répartis sur la périphérie de cette face arrière et débouchant sur cette face arrière,

Le procédé comprend également une fourniture d'un substrat porteur possédant une face avant possédant une zone destinée à être en vis-à vis de la face arrière de la puce et des zones de soudure à l'extérieur de cette zone.

Cette zone est une zone de placement au-dessus de laquelle la puce est destinée à se situer.

Le procédé comprend alors une formation à la périphérie de ladite zone de plusieurs deuxièmes orifices borgnes débouchant sur la face avant.

Le procédé comprend ensuite un remplissage des deuxièmes trous borgnes avec un premier matériau adhésif à l'état liquide en une quantité permettant d'obtenir un surplus de premier matériau débordant au-dessus des deuxièmes trous borgnes.

Ce surplus reste localisé dans le volume situé au-dessus de chaque deuxième orifice borgne par effet de bord et de par sa tension de surface.

On procède ensuite, typiquement juste après ledit remplissage, à un placement de la face arrière de la puce en face et à distance de ladite zone de façon à aligner respectivement les premiers trous borgnes et les deuxièmes trous borgnes et permettre une pénétration du surplus de premier matériau dans les premiers trous borgnes.

Le procédé comprend ensuite une solidification du premier matériau, typiquement par cuisson à une température appropriée, de façon à obtenir des piliers du premier matériau s'étendant dans chaque paire d'un premier orifice borgne et d'un deuxième orifice borgne et dans l'espace entre ce premier et ce deuxième orifices borgnes.

Puis on procède à une soudure de fils de liaison entre les plages de contact et les zones de soudure.

Le procédé comprend ensuite un enrobage des fils de liaison et d'au moins une partie de la puce électronique avec un matériau d'enrobage s'insérant en outre dans l'espace entre la face arrière de la puce et la face avant du substrat porteur.

Selon un mode de mise en œuvre, on forme au moins quatre premiers orifices borgnes et on forme au moins quatre deuxièmes orifices borgnes.

Selon un mode de mise en œuvre adapté à une puce rectangulaire, les quatre premiers orifices borgnes sont formés au voisinage des quatre coins de la face arrière de la puce.

De façon à augmenter la fixation de la puce sur le substrat porteur, on peut former sur la face arrière de la puce quatre autres premiers orifices borgnes respectivement disposés entre les quatre premiers orifices borgnes et on peut former sur la face avant du substrat porteur quatre autres deuxièmes orifices borgnes respectivement destinés à être situés en vis-à-vis des quatre autres premiers orifices borgnes lors du placement de la puce électronique.

On peut enrober totalement la puce électronique avec le matériau d'enrobage.

En variante et selon un mode de mise en œuvre, préalablement audit enrobage, on fixe un élément optiquement transparent, par exemple une glace, en face et à distance de la face avant de la puce par un cordon d'un deuxième matériau adhésif définissant avec la puce et l'élément optiquement transparent une cavité qui n'est pas remplie par le matériau d'enrobage lors de l'enrobage.

D'autres avantages et caractéristiques de l'invention apparaîtront à l'examen de la description détaillée de mode de réalisation et de mise en œuvre, nullement limitatifs, et des dessins annexés sur lesquels :
[Fig 1] ;
[Fig 2] ;
[Fig 3] ;
[Fig 4] ;
[Fig 5] ;
[Fig 6] ;
[Fig 7] ;et
[Fig 8] illustrent schématiquement des modes de mise en œuvre et de réalisation de l'invention.

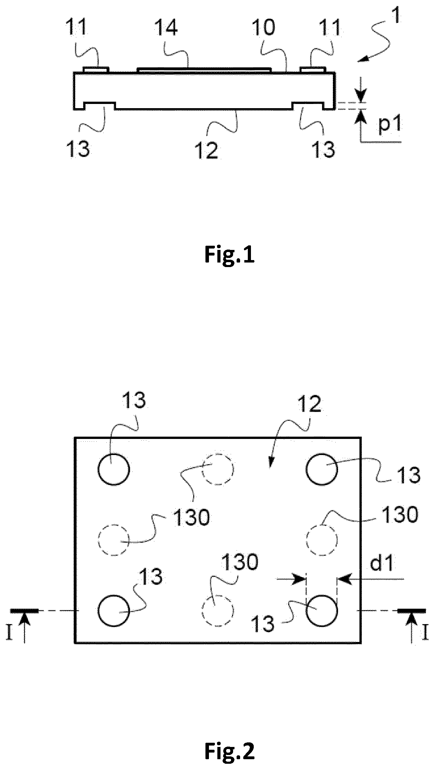

Sur la figure 1 et la figure 2 la référence 1 désigne une puce électronique.

La figure 1 est une vue en coupe selon la ligne I-I de la figure 2.

La puce électronique 1 comporte une face avant 10 possédant des plages de contact (« pads ») 11 et une face arrière 12.

La puce comporte ici également un dispositif optique 14 émetteur et/ou récepteur de signaux luminaux, monté sur la face avant 10 de la puce.

La face arrière 12 possède plusieurs premiers orifices borgnes 13 répartis sur la périphérie de la face arrière et débouchant sur cette face arrière.

Dans ce mode de réalisation il est prévu quatre premiers orifices borgnes 13.

Une puce est généralement rectangulaire (éventuellement avec des côtés égaux formant alors un carré).

Dans ce cas les quatre premiers orifices borgnes 13 sont de préférence, comme illustré sur la figure 2, disposés au voisinage des quatre coins de la face arrière 12 de la puce électronique.

Comme illustré sur la figure 2, la face arrière de la puce peut comporter quatre autres premiers orifices borgnes 130 respectivement disposés entre les quatre premiers orifices borgnes, par exemple au milieu des côtés de la face arrière 12.

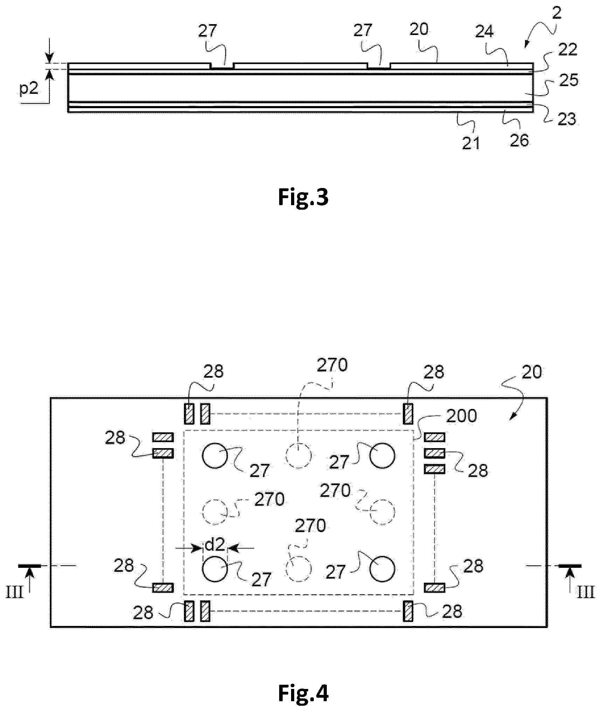

Sur les figures 3 et 4, la référence 2 désigne un substrat porteur.

La figure 3 est une vue en coupe selon la ligne III-III de la figure 4.

Le substrat porteur 2 possède une face avant (face supérieure ou face de montage) 20 et une face arrière (face inférieure) 21 opposée à la face avant.

Le substrat porteur 2 possède sur sa face avant une zone 200 qui est une zone de placement au-dessus de laquelle la puce 1 est destinée à se situer.

La face avant 20 du substrat porteur possède des zones de soudure (« bond fingers ») 28 à l'extérieur de la zone de placement 200 et plusieurs deuxièmes orifices borgnes 27, situés à la périphérie de la zone de placement 200, débouchant sur la face avant 20 et destinés à être respectivement en vis-à-vis des premiers orifices borgnes 13 de la puce 1.

Lorsque la face arrière de la puce électronique possède au quatre premiers orifices borgnes 13, la face avant du substrat porteur possède quatre deuxièmes orifices borgnes 27.

Si la face arrière de la puce comporte quatre autres premiers orifices borgnes 130, la face avant du substrat porteur comporte quatre autres deuxièmes orifices borgnes 270 destinés à être respectivement situés en vis-à-vis des quatre autres premiers orifices borgnes.

Le substrat porteur 2 est ici du type multicouches (connu par l'homme du métier sous l'expression anglosaxonne « laminate substrate »).

Un tel substrat porteur comporte une alternance de couches métalliques 22, 23 (seules deux sont représentées à des fins de simplification) et de couches électriquement isolantes 24, 25 26.

Des pistes métalliques formées dans les couches métalliques ainsi que des vias entre ces pistes permettent de réaliser un réseau d'interconnexion entre les zones de soudure 200 de la face avant (face supérieure) du substrat porteur et des billes de soudure (non représentées ici) disposées sur la face arrière (face inférieure) du substrat porteur et destinées à être soudées sur une carte de circuit imprimé.

La face supérieure de la couche électriquement isolante supérieure du substrat porteur forme la face avant de ce substrat porteur et les deuxièmes orifices borgnes 27 sont ici ménagés dans la couche électriquement isolante supérieure 24 et ont une profondeur p2 correspondant à l'épaisseur de cette couche isolante supérieure 24.

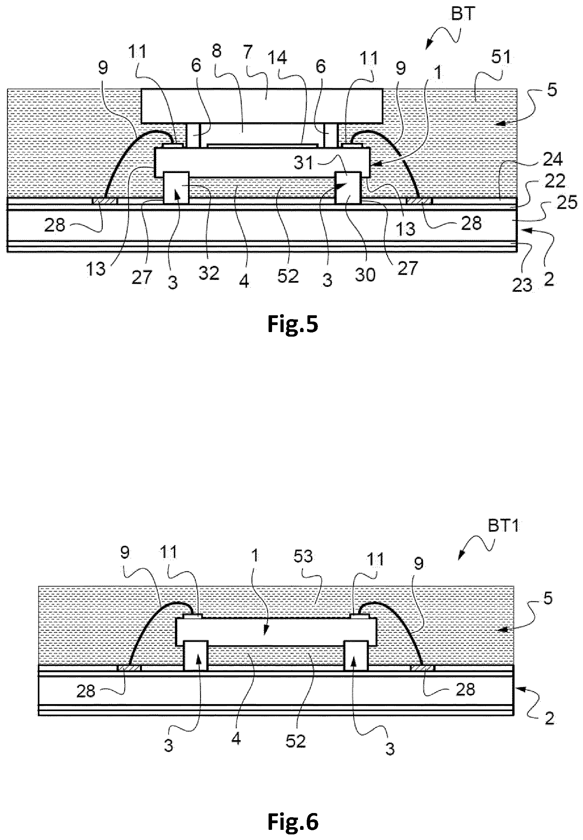

La figure 5 illustre schématiquement un premier mode de réalisation d'un boîtier BT comportant la puce 1 et le substrat porteur 2 précédemment décrits.

La face arrière 12 de la puce et la face avant 20 du substrat sont en vis-à-vis en laissant un espace 4 entre elles.

Les premiers orifices borgnes 13 de la puce sont respectivement en vis-à-vis des deuxièmes orifices borgnes 27 du substrat porteur.

Chaque paire d'un premier orifice borgne 13 et d'un deuxième orifice borgne 27 mutuellement en vis-à-vis définit un logement.

Le boîtier BT comporte alors dans chaque logement, un pilier 3 d'un premier matériau adhésif, par exemple un pilier de colle solidifiée.

Chaque pilier 3 comporte
- une partie inférieure 30 logée dans le deuxième orifice borgne correspondant 27,
- une partie supérieure 30 logée dans le premier orifice borgne correspondant 13, et
- une partie intermédiaire 32 entre les parties 30 et 31 située dans l'espace entre la puce et le substrat porteur.

Le boîtier BT comporte également des fils de liaison électriquement conducteurs 9 entre les plages de contact 11 de la puce et les zones de soudure 28 du substrat porteur.

La puce électronique 1 est fixée sur le substrat porteur 2 par l'intermédiaire des piliers de matériau adhésif 3.

Et ce matériau adhésif est contenu dans chaque logement formé par une paire d'un premier orifice borgne 13 et d'un deuxième orifice borgne 27 mutuellement en vis à vis.

Il n'y a donc aucune contamination des plages de contact 11 et des zones de soudure 28 par le premier matériau adhésif, ce qui permet d'obtenir une soudure correcte des fils de liaison 9 d'une part sur ces plages de contact 11 et d'autre part sur les zones de soudure 28.

Le boîtier BT est ici un boîtier optique comportant un élément optiquement transparent 7, par exemple une glace, situé en face et à distance de la face avant de la puce sur laquelle est fixé le dispositif optique 14.

L'élément optiquement transparent 7 est fixé sur la face avant de la puce par un cordon 6 d'un deuxième matériau adhésif, par exemple un cordon de colle.

Ce deuxième matériau adhésif peut être identique ou différent du premier matériau adhésif formant les piliers 3.

Ce cordon 6 du deuxième matériau adhésif définit avec la puce 1 et l'élément optiquement transparent 7 une cavité 8.

Le boîtier BT comporte encore un matériau d'enrobage 5, par exemple une résine de moulage, enrobant les fils de liaison 9 et partiellement la puce électronique 1.

Une partie 52 de ce matériau d'enrobage est situé dans l'espace entre la face arrière de la puce et la face avant du substrat porteur.

Une autre partie 51 du matériau d'enrobage enrobe latéralement la puce 1, l'élément optiquement transparent 4 et le cordon adhésif 6.

La cavité 8 n'est pas remplie par le matériau d'enrobage 5.

Pour certains boîtiers, le matériau d'enrobage enrobe totalement la puce électronique.

C'est le cas par exemple du boîtier BT1 illustré schématiquement sur la figure 6.

Ce boîtier est un boîtier non optique.

Sur les figures 5 et 6 les éléments analogues ou ayant des fonctions analogues ont les mêmes références.

Seules les différences entre la figure 5 et la figure 6 seront maintenant décrites.

La face avant de la puce 1 ne comporte pas de dispositif optique et le boîtier BT1 ne comporte pas d'élément optiquement transparent en regard de la face avant de la puce 1.

Le matériau d'enrobage 5 comporte ici une partie supérieure 53 venant recouvrir la puce 1.

D'une façon générale l'homme du métier saura définir les caractéristiques géométriques des premiers trous borgnes et des deuxièmes trous borgnes ainsi que la quantité de premier matériau adhésif de façon à obtenir des piliers adhésifs remplissant ces orifices borgnes tout en ménageant un espace entre la face arrière de la puce et la face avant du substrat porteur.

A titre indicatif les deuxièmes orifices borgnes 27 peuvent avoir une profondeur p2 (figure 3) de 25 micromètres à 10% près.

Les deuxièmes orifices borgnes 27 peuvent avoir à titre d'exemple, une ouverture d2 (figure 2) de 200 micromètres à 10% près.

Les premiers orifices borgnes 13 (ménagés sur la face arrière de la puce) peuvent avoir une profondeur p1 (figure 1) inférieure à celle des deuxièmes orifices borgnes, par exemple une profondeur p1 de 10 micromètres à 10% près.

Chaque pilier du premier matériau adhésif 3 peut déborder de 20 micromètres à 10% près, au-dessus de la face avant du substrat porteur, ce qui représente la hauteur de la partie intermédiaire 32 de ce pilier.

L'espace entre la face arrière de la puce électronique et la face avant du substrat a alors cette valeur de 20 micromètres à 10% près.

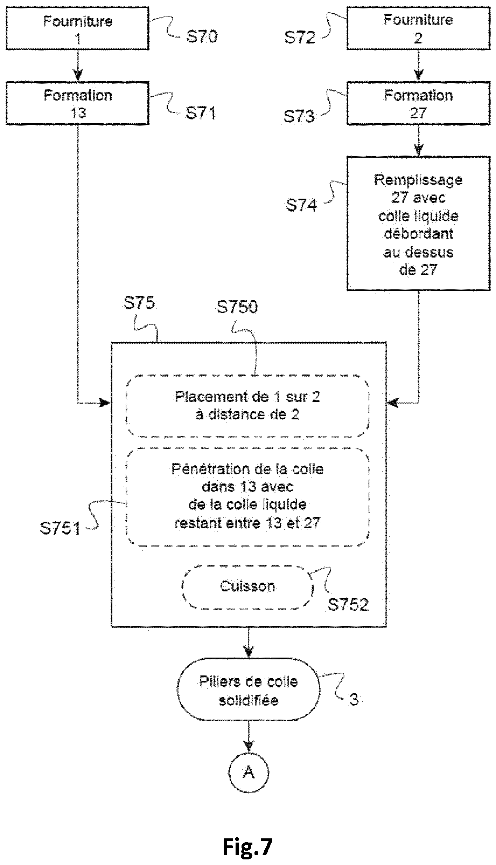

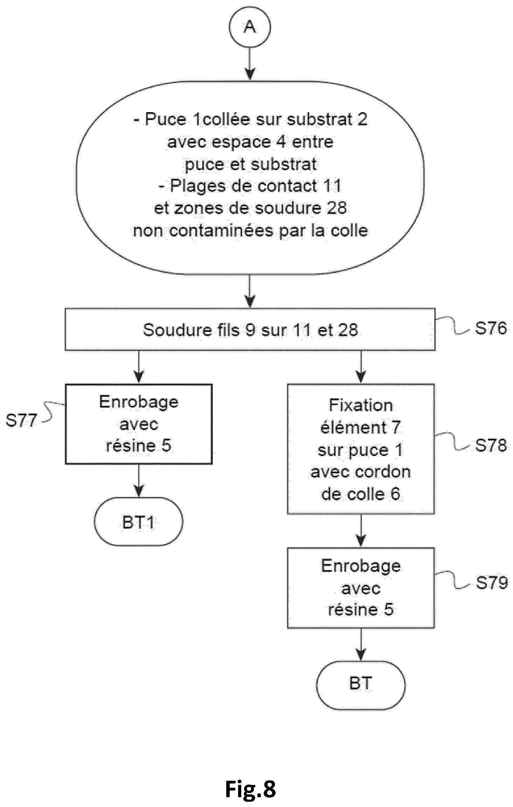

On se réfère maintenant plus particulièrement aux figures 7 et 8 pour décrire un mode de mise en œuvre d'un procédé de fabrication d'un boîtier selon l'invention.

Ce procédé comprend une fourniture S70 d'une puce électronique 1 comportant une face avant possédant des plages de contact et une face arrière.

On forme (étape S71) sur ladite face arrière plusieurs premiers orifices borgnes 13 répartis sur la périphérie de cette face arrière et débouchant sur cette face arrière,

Le procédé comprend également une fourniture S72 d'un substrat porteur 2 possédant une face avant possédant une zone de placement 200 destinée à être en vis-à vis de la face arrière de la puce et des zones de soudure 28 à l'extérieur de cette zone de placement 200.

Le procédé comprend alors une formation S73 à la périphérie de ladite zone 200 de plusieurs deuxièmes orifices borgnes 27 débouchant sur la face avant.

Le procédé comprend ensuite un remplissage S74 des deuxièmes trous borgnes 27 avec un premier matériau adhésif à l'état liquide en une quantité permettant d'obtenir un surplus de premier matériau débordant au-dessus des deuxièmes trous borgnes 27.

Ce premier matériau adhésif peut être par exemple la colle commercialisée sous la référence ABLESTIK QMI536 par la société Loctite et le remplissage des deuxièmes trous borgnes peut s'effectuer classiquement à l'aide d'une seringue.

Le surplus de colle reste localisé dans le volume situé au-dessus de chaque deuxième orifice borgne 27 par effet de bord et de par la tension de surface de la colle à l'état liquide.

L'étape suivante S75 permet de fixer la puce sur le substrat porteur à l'aide des piliers de colle 3.

Plus précisément juste après ledit remplissage des deuxièmes trous borgnes 27, on procède à un placement S750 de la face arrière de la puce en face et à distance de ladite zone de placement 200 du substrat porteur de façon à aligner respectivement les premiers trous borgnes 13 et les deuxièmes trous borgnes 27 et permettre une pénétration S751 du surplus de colle dans les premiers trous borgnes 13.

Le procédé comprend ensuite une solidification S752 du premier matériau, typiquement par cuisson à une température appropriée, par exemple 150°C pendant une durée de 90 minutes, de façon à obtenir les piliers 3 de colle solidifiée s'étendant dans chaque paire d'un premier orifice borgne 13 et d'un deuxième orifice borgne 27 et dans l'espace entre ce premier et ce deuxième orifices borgnes.

A ce stade la puce électronique 1 est collée sur le substrat porteur 2 avec un espace 4 entre la puce et le substrat porteur.

Les plages de contact 11 et les zones de soudure 28 ne sont pas contaminées par la colle.

Puis on procède à une soudure S76 des fils de liaison 9 entre les plages de contact 11 et les zones de soudure 28.

A partir de là, deux variantes sont possibles.

Dans une première variante on procède à un enrobage total S77 des fils de liaison et de la puce électronique avec un matériau d'enrobage, par exemple une résine de moulage classique, s'insérant en outre dans l'espace 4 entre la face arrière de la puce et la face avant du substrat porteur, de façon à obtenir un boîtier BT1 du type de celui illustré sur la figure 6.

Dans une deuxième variante, préalablement audit enrobage, on fixe (étape S78) l'élément optiquement transparent7 en face et à distance de la face avant de la puce par un cordon 6 d'un deuxième matériau adhésif définissant avec la puce et l'élément optiquement transparent la cavité 8 qui n'est pas remplie par le matériau d'enrobage, par exemple la résine de moulage, lors de l'enrobage S79.

Dans cet exemple le deuxième matériau adhésif peut être la colle utilisée pour la formation des piliers 3.

## Revendications

1. Boîtier, comprenant
- une puce électronique (1) comportant une face avant (10) possédant des plages de contact (11) et une face arrière (12) possédant plusieurs premiers orifices borgnes (13) répartis sur sa périphérie et débouchant sur la face arrière,
- un substrat porteur (2) possédant une face avant (20) en vis-à-vis et à distance de la face arrière (12) de la puce et possédant des zones de soudure (28) et au plusieurs deuxièmes orifices borgnes (27) débouchant sur la face avant respectivement en vis-à-vis des premiers orifices borgnes (13) de la puce, chaque paire d'un premier orifice borgne (13) et d'un deuxième orifice borgne (27) mutuellement en vis-à-vis définissant un logement,
- un pilier (3) d'un premier matériau adhésif dans chaque logement,
- des fils de liaison (9) entre les plages de contact (11) et les zones de soudure (28),
- un matériau d'enrobage (5) enrobant les fils de liaison (9) et au moins partiellement la puce électronique, une partie (52) de ce matériau d'enrobage étant situé dans l'espace (4) entre la face arrière (12) de la puce et la face avant (20) du substrat porteur.

2. Boîtier selon la revendication 1, dans lequel la face arrière de la puce électronique possède au moins quatre premiers orifices borgnes (13) et la face avant du substrat porteur possède au moins quatre deuxièmes orifices borgnes (27).

3. Boîtier selon la revendication 2, dans lequel la puce est rectangulaire et les quatre premiers orifices borgnes (13) sont disposés au voisinage des quatre coins de la face arrière (12) de la puce.

4. Boîtier selon la revendication 2 ou 3, dans lequel la face arrière de la puce comporte quatre autres premiers orifices borgnes (130) respectivement disposés entre les quatre premiers orifices borgnes (13) et la face avant du substrat porteur comporte quatre autres deuxièmes orifices borgnes (270) respectivement situés en vis-à-vis des quatre autres premiers orifices borgnes (130).

5. Boîtier selon l'une des revendications précédentes, dans lequel le matériau d'enrobage (5) enrobe totalement la puce électronique.

6. Boîtier selon l'une des revendications 1 à 4, dans lequel le boîtier est un boîtier optique (BT) comportant un élément optiquement transparent (7) situé en face et à distance de la face avant de la puce et fixé sur cette face avant par un cordon (6) d'un deuxième matériau adhésif définissant avec la puce et l'élément optiquement transparent une cavité (8) qui n'est pas remplie par le matériau d'enrobage (5).

7. Boîtier selon l'une des revendications précédentes, dans lequel les deuxièmes orifices borgnes (27) ont une profondeur de 25 micromètres à 10% près.

8. Boîtier selon l'une des revendications précédentes, dans lequel le substrat porteur (2) est du type multicouches comportant une alternance de couches métalliques et de couches électriquement isolantes, la face supérieure de la couche électriquement isolante supérieure (24) formant la face avant (20) du substrat porteur et les deuxièmes orifices borgnes (27) sont ménagés dans la couche électriquement isolante supérieure (24) et ont une profondeur correspondant à l'épaisseur de cette couche isolante supérieure.

9. Boîtier selon l'une des revendications précédentes, dans lequel les deuxièmes orifices borgnes (27) ont une ouverture de 200 micromètres à 10% près.

10. Boîtier selon l'une des revendications précédentes, dans lequel les premiers orifices borgnes (13) ont une profondeur de 10 micromètres à 10% près.

11. Boîtier selon l'une des revendications précédentes, dans lequel chaque pilier (3) du premier matériau adhésif déborde de 20 micromètres à 10% près, au-dessus de la face avant du substrat porteur.

12. Procédé de fabrication d'un boîtier, comprenant
- une fourniture (S70) d'une puce électronique comportant une face avant possédant des plages de contact et une face arrière,
- une formation (S71) sur ladite face arrière de plusieurs premiers orifices borgnes répartis sur la périphérie de cette face arrière et débouchant sur cette face arrière,
- une fourniture (S72) d'un substrat porteur possédant une face avant possédant une zone (200) destinée à être en vis-à vis de la face arrière de la puce et des zones de soudure à l'extérieur de cette zone (200),
- une formation (S73) à la périphérie de ladite zone de plusieurs deuxièmes orifices borgnes débouchant sur la face avant,
- un remplissage (S74) des deuxièmes trous borgnes avec un premier matériau adhésif à l'état liquide en une quantité permettant d'obtenir un surplus de premier matériau débordant au-dessus des deuxièmes trous borgnes,
- un placement (S750) de la face arrière de la puce en face et à distance de ladite zone de façon à aligner respectivement les premiers trous borgnes et les deuxièmes trous borgnes et permettre une pénétration (S751) du surplus de premier matériau dans les premiers trous borgnes, et une solidification (S752) du premier matériau de façon à obtenir des piliers du premier matériau s'étendant dans chaque paire d'un premier orifice borgne et d'un deuxième orifice borgne et dans l'espace entre ce premier et ce deuxième orifices borgnes,
une soudure (S76) de fils de liaison entre les plages de contact et les zones de soudure,
- un enrobage (S77 ; S79) des fils de liaison et d'au moins une partie de la puce électronique avec un matériau d'enrobage s'insérant en outre dans l'espace entre la face arrière de la puce et la face avant du substrat porteur.

13. Procédé selon la revendication 12, dans lequel on forme au moins quatre premiers orifices borgnes (13) et on forme au moins quatre deuxièmes orifices borgnes (27).

14. Procédé selon la revendication 13, dans lequel la puce est rectangulaire et les quatre premiers orifices borgnes (13) sont formés au voisinage des quatre coins de la face arrière de la puce.

15. Procédé selon la revendication 14, dans lequel on forme sur la face arrière de la puce quatre autres premiers orifices borgnes (130) respectivement disposés entre les quatre premiers orifices borgnes et on forme sur la face avant du substrat porteur quatre autres deuxièmes orifices borgnes (270) respectivement destinés à être situés en vis-à-vis des quatre autres premiers orifices borgnes lors du placement de la puce électronique.

16. Procédé selon l'une des revendications 12 à 15, dans lequel on enrobe (S77) totalement la puce électronique avec le matériau d'enrobage.

17. Procédé selon l'une des revendications 12 à 15, dans lequel préalablement audit enrobage (S79), on fixe (S78) un élément optiquement transparent en face et à distance de la face avant de la puce par un cordon d'un deuxième matériau adhésif définissant avec la puce et l'élément optiquement transparent une cavité qui n'est pas remplie par le matériau d'enrobage lors de l'enrobage.

## Patentansprüche

1. Gehäuse, umfassend
- einen elektronischen Chip (1), der eine Vorderseite (10) mit Kontaktflächen (11) und eine Rückseite (12) mit mehreren ersten Sacklöchern (13), die an deren Umfang verteilt sind und an der Rückseite münden, aufweist,
- ein Trägersubstrat (2), das eine Vorderseite (20) aufweist, die der Rückseite (12) des Chips gegenüberliegt und von dieser beabstandet ist, und das Bondbereiche (28) und mehrere zweite Sacklöcher (27) aufweist, die an der Vorderseite münden und jeweils den ersten Sacklöchern (13) des Chips gegenüberliegen, wobei jedes Paar aus einem ersten Sackloch (13) und einem zweiten Sackloch (27), die einander gegenüberliegen, einen Aufnahmeraum definiert,
- einen Pfeiler (3) aus einem ersten Klebstoffmaterial in jedem Aufnahmeraum,
- Verbindungsdrähte (9) zwischen den Kontaktflächen (11) und den Bondbereichen (28),
- ein Verkapselungsmaterial (5), das die Verbindungsdrähte (9) und zumindest teilweise den elektronischen Chip verkapselt, wobei ein Teil (52) dieses Verkapselungsmaterials in dem Raum (4) zwischen der Rückseite (12) des Chips und der Vorderseite (20) des Trägersubstrats angeordnet ist.

2. Gehäuse nach Anspruch 1, bei dem die Rückseite des elektronischen Chips mindestens vier erste Sacklöcher (13) und die Vorderseite des Trägersubstrats mindestens vier zweite Sacklöcher (27) aufweist.

3. Gehäuse nach Anspruch 2, bei dem der Chip rechteckig ist und die vier ersten Sacklöcher (13) in der Nähe der vier Ecken der Rückseite (12) des Chips angeordnet sind.

4. Gehäuse nach Anspruch 2 oder 3, bei dem die Rückseite des Chips vier weitere erste Sacklöcher (130) aufweist, die jeweils zwischen den vier ersten Sacklöchern (13) angeordnet sind, und die Vorderseite des Trägersubstrats vier weitere zweite Sacklöcher (270) aufweist, die jeweils den vier weiteren ersten Sacklöchern (130) gegenüberliegen.

5. Gehäuse nach einem der vorhergehenden Ansprüche, bei dem das Verkapselungsmaterial (5) den elektronischen Chip vollständig verkapselt.

6. Gehäuse nach einem der Ansprüche 1 bis 4, bei dem das Gehäuse ein optisches Gehäuse (BT) ist, das ein optisch transparentes Element (7) umfasst, das der Vorderseite des Chips gegenüberliegt und von dieser beabstandet ist und an dieser Vorderseite durch eine Raupe (6) aus einem zweiten Klebstoffmaterial befestigt ist, die zusammen mit dem Chip und dem optisch transparenten Element einen Hohlraum (8) definiert, der nicht mit dem Verkapselungsmaterial (5) gefüllt ist.

7. Gehäuse nach einem der vorhergehenden Ansprüche, bei dem die zweiten Sacklöcher (27) eine Tiefe von 25 Mikrometern mit einer Toleranz von 10 % aufweisen.

8. Gehäuse nach einem der vorhergehenden Ansprüche, bei dem das Trägersubstrat (2) vom Mehrschichttyp ist und eine alternierende Anordnung von Metallschichten und elektrisch isolierenden Schichten aufweist, wobei die Oberseite der oberen elektrisch isolierenden Schicht (24) die Vorderseite (20) des Trägersubstrats bildet und die zweiten Sacklöcher (27) in der oberen elektrisch isolierenden Schicht (24) ausgebildet sind und eine Tiefe aufweisen, die der Dicke dieser oberen Isolierschicht entspricht.

9. Gehäuse nach einem der vorhergehenden Ansprüche, bei dem die zweiten Sacklöcher (27) eine Öffnung von 200 Mikrometern mit einer Toleranz von 10 % aufweisen.

10. Gehäuse nach einem der vorhergehenden Ansprüche, bei dem die ersten Sacklöcher (13) eine Tiefe von 10 Mikrometern mit einer Toleranz von 10 % aufweisen.

11. Gehäuse nach einem der vorhergehenden Ansprüche, bei dem jeder Pfeiler (3) aus dem ersten Klebstoffmaterial um 20 Mikrometer mit einer Toleranz von 10 % über die Vorderseite des Trägersubstrats hinausragt.

12. Verfahren zur Herstellung eines Gehäuses, umfassend
- ein Bereitstellen (S70) eines elektronischen Chips, der eine Vorderseite mit Kontaktflächen und eine Rückseite aufweist,
- ein Ausbilden (S71) mehrerer erster Sacklöcher auf der genannten Rückseite, die am Umfang dieser Rückseite verteilt sind und an dieser Rückseite münden,
- ein Bereitstellen (S72) eines Trägersubstrats, das eine Vorderseite mit einem Bereich (200), der dazu bestimmt ist, der Rückseite des Chips gegenüberzuliegen, und Bondbereichen außerhalb dieses Bereichs (200) aufweist,
- ein Ausbilden (S73) mehrerer zweiter Sacklöcher am Umfang des genannten Bereichs, die an der Vorderseite münden,
- ein Befüllen (S74) der zweiten Sacklöcher mit einem ersten Klebstoffmaterial im flüssigen Zustand in einer Menge, die es ermöglicht, einen Überschuss an erstem Material zu erhalten, der über die zweiten Sacklöcher hinausragt,
- ein Platzieren (S750) der Rückseite des Chips gegenüber und im Abstand von dem genannten Bereich, um jeweils die ersten Sacklöcher und die zweiten Sacklöcher aufeinander auszurichten und ein Eindringen (S751) des Überschusses an erstem Material in die ersten Sacklöcher zu ermöglichen, und ein Verfestigen (S752) des ersten Materials, um Pfeiler aus dem ersten Material zu erhalten, die sich in jedes Paar aus einem ersten Sackloch und einem zweiten Sackloch sowie in den Raum zwischen diesem ersten und diesem zweiten Sackloch erstrecken,
ein Bonden (S76) von Verbindungsdrähten zwischen den Kontaktflächen und den Bondbereichen,
- ein Verkapseln (S77 ; S79) der Verbindungsdrähte und zumindest eines Teils des elektronischen Chips mit einem Verkapselungsmaterial, das außerdem in den Raum zwischen der Rückseite des Chips und der Vorderseite des Trägersubstrats eindringt.

13. Verfahren nach Anspruch 12, bei dem mindestens vier erste Sacklöcher (13) ausgebildet werden und mindestens vier zweite Sacklöcher (27) ausgebildet werden.

14. Verfahren nach Anspruch 13, bei dem der Chip rechteckig ist und die vier ersten Sacklöcher (13) in der Nähe der vier Ecken der Rückseite des Chips ausgebildet werden.

15. Verfahren nach Anspruch 14, bei dem auf der Rückseite des Chips vier weitere erste Sacklöcher (130) ausgebildet werden, die jeweils zwischen den vier ersten Sacklöchern angeordnet sind, und auf der Vorderseite des Trägersubstrats vier weitere zweite Sacklöcher (270) ausgebildet werden, die jeweils dazu bestimmt sind, beim Platzieren des elektronischen Chips den vier weiteren ersten Sacklöchern gegenüberzuliegen.

16. Verfahren nach einem der Ansprüche 12 bis 15, bei dem der elektronische Chip vollständig mit dem Verkapselungsmaterial verkapselt wird (S77).

17. Verfahren nach einem der Ansprüche 12 bis 15, bei dem vor dem genannten Verkapseln (S79) ein optisch transparentes Element gegenüber und im Abstand von der Vorderseite des Chips durch eine Raupe aus einem zweiten Klebstoffmaterial befestigt wird (S78), die zusammen mit dem Chip und dem optisch transparenten Element einen Hohlraum definiert, der beim Verkapseln nicht mit dem Verkapselungsmaterial gefüllt wird.

## Claims

1. A package, comprising
- an electronic chip (1) comprising a front face (10) having contact pads (11) and a rear face (12) having several first blind holes (13) distributed along its periphery and opening onto the rear face,
- a carrier substrate (2) having a front face (20) facing and spaced apart from the rear face (12) of the chip and having bonding areas (28) and several second blind holes (27) opening onto the front face respectively facing the first blind holes (13) of the chip, each pair of a first blind hole (13) and a second blind hole (27) mutually facing each other defining a receptacle,
- a pillar (3) of a first adhesive material in each receptacle,
- connection wires (9) between the contact pads (11) and the bonding areas (28),
- an encapsulation material (5) encapsulating the connection wires (9) and at least partially the electronic chip, a portion (52) of this encapsulation material being located in the space (4) between the rear face (12) of the chip and the front face (20) of the carrier substrate.

2. A package according to claim 1, wherein the rear face of the electronic chip has at least four first blind holes (13) and the front face of the carrier substrate has at least four second blind holes (27).

3. A package according to claim 2, wherein the chip is rectangular and the four first blind holes (13) are arranged in the vicinity of the four corners of the rear face (12) of the chip.

4. A package according to claim 2 or 3, wherein the rear face of the chip comprises four other first blind holes (130) respectively arranged between the four first blind holes (13) and the front face of the carrier substrate comprises four other second blind holes (270) respectively located facing the four other first blind holes (130).

5. A package according to any one of the preceding claims, wherein the encapsulation material (5) completely encapsulates the electronic chip.

6. A package according to any one of claims 1 to 4, wherein the package is an optical package (BT) comprising an optically transparent element (7) located facing and spaced apart from the front face of the chip and fixed to this front face by a bead (6) of a second adhesive material defining, together with the chip and the optically transparent element, a cavity (8) that is not filled with the encapsulation material (5).

7. A package according to any one of the preceding claims, wherein the second blind holes (27) have a depth of 25 micrometres to within 10%.

8. A package according to any one of the preceding claims, wherein the carrier substrate (2) is of the multilayer type comprising an alternation of metallic layers and electrically insulating layers, the upper face of the upper electrically insulating layer (24) forming the front face (20) of the carrier substrate and the second blind holes (27) are formed in the upper electrically insulating layer (24) and have a depth corresponding to the thickness of this upper insulating layer.

9. A package according to any one of the preceding claims, wherein the second blind holes (27) have an opening of 200 micrometres to within 10%.

10. A package according to any one of the preceding claims, wherein the first blind holes (13) have a depth of 10 micrometres to within 10%.

11. A package according to any one of the preceding claims, wherein each pillar (3) of the first adhesive material protrudes by 20 micrometres to within 10% above the front face of the carrier substrate.

12. A method for manufacturing a package, comprising
- a provision (S70) of an electronic chip comprising a front face having contact pads and a rear face,
- a formation (S71) on said rear face of several first blind holes distributed along the periphery of this rear face and opening onto this rear face,
- a provision (S72) of a carrier substrate having a front face having a region (200) intended to face the rear face of the chip and bonding areas outside this region (200),
- a formation (S73) at the periphery of said region of several second blind holes opening onto the front face,
- a filling (S74) of the second blind holes with a first adhesive material in the liquid state in an amount allowing a surplus of first material protruding above the second blind holes to be obtained,
- a positioning (S750) of the rear face of the chip facing and spaced apart from said region so as to respectively align the first blind holes and the second blind holes and allow penetration (S751) of the surplus of first material into the first blind holes, and a solidification (S752) of the first material so as to obtain pillars of the first material extending into each pair of a first blind hole and a second blind hole and into the space between this first blind hole and this second blind hole,
a bonding (S76) of connection wires between the contact pads and the bonding areas,
- an encapsulation (S77 ; S79) of the connection wires and of at least a portion of the electronic chip with an encapsulation material also entering the space between the rear face of the chip and the front face of the carrier substrate.

13. A method according to claim 12, wherein at least four first blind holes (13) are formed and at least four second blind holes (27) are formed.

14. A method according to claim 13, wherein the chip is rectangular and the four first blind holes (13) are formed in the vicinity of the four corners of the rear face of the chip.

15. A method according to claim 14, wherein four other first blind holes (130) respectively arranged between the four first blind holes are formed on the rear face of the chip and four other second blind holes (270) respectively intended to be located facing the four other first blind holes during the positioning of the electronic chip are formed on the front face of the carrier substrate.

16. A method according to any one of claims 12 to 15, wherein the electronic chip is completely encapsulated (S77) with the encapsulation material.

17. A method according to any one of claims 12 to 15, wherein, prior to said encapsulation (S79), an optically transparent element is fixed (S78) facing and spaced apart from the front face of the chip by a bead of a second adhesive material defining, together with the chip and the optically transparent element, a cavity that is not filled with the encapsulation material during the encapsulation.
